Europäisches Patentamt

European Patent Office

Office européen des brevets

(19)

(11) Numéro de publication: **0 409 706 A1**

# DEMANDE DE BREVET EUROPEEN

(12)

(21) Numéro de dépôt: **90402031.0**

(22) Date de dépôt: **13.07.90**

(51) Int. Cl.5: **H03K 3/284**

(30) Priorité: **19.07.89 FR 8909703**

(43) Date de publication de la demande:
**23.01.91 Bulletin 91/04**

(84) Etats contractants désignés:
**DE GB**

(71) Demandeur: **MATRA COMMUNICATION**
**50, rue du Président Sadatte Creac'h Gwenn**
**F-29101 Quimper(FR)**

(72) Inventeur: **Jolivet, André**
**10 ter rue Madame**
**F-78000 Versailles(FR)**

(74) Mandataire: **Fruchard, Guy et al**
**CABINET BOETTCHER 23, rue la Boétie**
**F-75008 Paris(FR)**

(54) **Générateur d'impulsion fines.**

(57) Le générateur selon l'invention comprend un premier transistor (1) et un second transistor (2) reliés à une alimentation stabilisée (6) par l'intermédiaire de résistances d'adaptation (7,13), le premier transistor ayant une borne d'entrée (3) reliée à une source de signaux (4) comportant une série de fronts de tension, une borne de sortie (8) reliée d'une part à une inductance (9) et d'autre part à une borne de commande (10) du second transistor, et une borne de commande (11) reliée à une borne d'entrée (12) du second transistor, le second transistor ayant en outre une borne de sortie (14) reliée à une résistance de charge (15) et à une borne de sortie du générateur d'impulsions.

## LA PRÉSENTE INVENTION CONCERNE UN GÉNÉRATEUR D'IMPULSIONS FINES

On sait que pour obtenir un spectre de raies notamment pour l'asservissement d'un oscillateur destiné à générer une onde porteuse locale dans un système de radio-communication, il est nécessaire de générer des impulsions fines qui doivent être d'autant plus fines que l'on désire avoir un spectre de raies large . On sait générer des impulsions fines à partir d'un signal périodique au moyen d'un circuit comportant une diode. Toutefois, les diodes adaptées à générer des impulsions fines à partir d'un signal périodique sont des composants chers et l'expansion continue des systèmes des radio-communications amène à rechercher des dispositifs de moindre coût pouvant être diffusés plus largement.

Un but de l'invention est de proposer un générateur d'impulsions fines de coût très faible.

En vue de la réalisation de ce but, on prévoit selon l'invention un générateur d'impulsions fines comprenant un premier et un second transistor reliés à une alimentation stabilisée par l'intermédiaire de résistances d'adaptation, le premier transistor ayant une borne d'entrée reliée à une source de signaux comportant une série de fronts de tension, une borne de sortie reliée d'une part à une inductance et, d'autre part, à une borne de commande du second transistor, et une borne de commande reliée à une borne d'entrée du second transistor, le second transistor ayant en outre une borne de sortie reliée à une résistance de charge et à une borne de sortie du générateur d'impulsions.

Ainsi, compte tenu du coût très faible des transistors qui sont actuellement fabriqués en très grande série, le coût global du générateur est très faible par rapport à celui des générateurs comportant une diode pour la génération des impulsions.

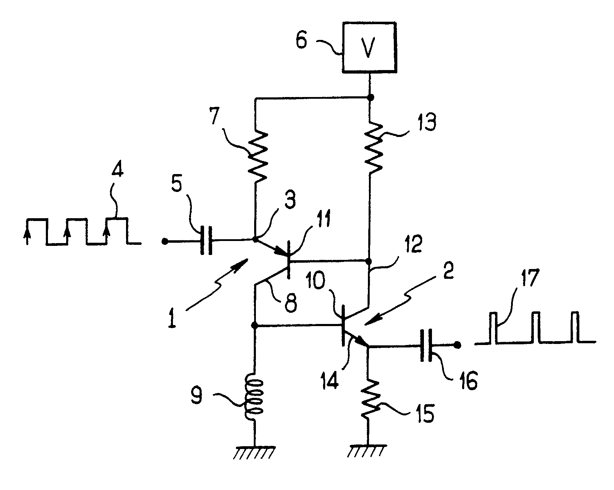

D'autres caractéristiques et avantages de l'invention apparaîtront à la lecture de la description qui suit d'un mode de réalisation particulier non limitatif de l'invention, en liaison avec la figure unique ci-jointe qui est un schéma du générateur d'impulsions selon l'invention.

Le générateur d'impulsions fines selon l'invention comporte un premier transistor généralement désigné en 1 et un second transistor généralement désigné en 2. Dans le mode de réalisation illustré, le premier transistor 1 est un transistor PNP tandis que le second transistor est un transistor NPN. l'émetteur 3 du premier transistor est relié d'une part à une source de signaux en créneaux 4 par l'intermédiaire d'un condensateur de découplage 5, et d'autre part, à une alimentation stabilisée 6 délivrant une tension continue positive V par l'intermédiaire d'une résistance d'adaptation 7.

Le collecteur 8 du premier transistor est relié à la masse par l'intermédiaire d'une inductance 9, ainsi qu'à la base 10 du second transistor. La base 11 du premier transistor estreliée au collecteur 12 du second transistor, ce collecteur 12 étant luimême relié à l'alimentation stabilisée 6 par l'intermédiaire d'une résistance d'adaptation 13. L'émetteur 14 du second transistor est relié d'une part à la masse par l'intermédiaire d'une résistance de charge 15 et d'autre part, à la sortie du générateur d'impulsions par l'intermédiaire d'un condensateur de découplage 16.

Ainsi, dans le premier transistor 1, l'émetteur 3, le collecteur 8 et la base 11 forment respectivement une borne d'entrée, une borne de sortie et une borne de commande, tandis que dans le second transistor 2, le collecteur 12, l'émetteur 14 et la base 10 forment respectivement une borne d'entrée, une borne de sortie et une borne de commande du second transistor.

Le générateur d'impulsions selon l'invention fonctionne de la façon suivante : lorsque le générateur est seulement alimenté par la tension d'alimentation, les deux transistors sont bloqués et aucun courant ne traverse le générateur. Il en est de même lorsque la borne d'entrée 3 du premier transistor est soumise à un front descendant ou à un palier du signal en créneaux 4. Lorsqu'un front montant du signal en créneaux 4 atteint la borne d'entrée 3 du premier transistor, celui-ci se met à conduire et un courant croissant traverse le premier transistor de l'émetteur 3 au collecteur 8. En raison de la position de l'inductance 9, une tension proportionnelle à la dérivée du courant traversant le premier transistor apparaît à la borne de sortie 8 de ce premier transistor, de sorte que le second transistor se met à son tour à conduire. En raison de la boucle formée par le premier et le second transistors, ceux-ci se mettent à conduire de plus en plus fort jusqu'au moment où le transistor 1 est saturé. La tension dérivée du courant à la borne de sortie 8 du premier transistor disparaît alors et provoque le blocage du second transistor. Parallèlement, le front montant du signal en créneau 4 n'étant plus présent à la borne d'entrée 3 du premier transistor, celui-ci se bloque à son tour et le générateur est donc revenu à la position de repos en attendant le front montant suivant du signal en créneau 4.

On remarque donc qu'à chaque fois que le transistor 2 conduit on recueille un signal sur la borne de sortie 14 du second transistor. En raison de la très grande rapidité du phénomène d'avalanche qui amène le premier transistor à saturation dès que le second transistor se met à conduire, la tension de sortie du second transistor se présente sous forme d'impulsions fines 17 ayant la même périodicité que les fronts montant du signal en créneaux 4.

Bien entendu l'invention n'est pas limitéeau mode de réalisation décrit et on peut y apporter des variantes de réalisation sans sortir du cadre de l'invention. En particulier, bien que l'invention ait été décrite avec un premier transistor du type PNP et un second transistor du type NPN associés à une source d'alimentation continue de tension positive, le générateur selon l'invention peut être réalisé en utilisant d'autres types de transistors et en adaptant le circuit de façon correspondante pour que le premier et le second transistor réalisent une boucle fermée dont le produit des deux gains est positif, l'inductance étant disposée dans cette boucle pour assurer un blocage du second transistor tant que le premier transistor n'est pas conducteur ou dès qu'il atteint la saturation.

## Revendications

1. Générateur d'impulsions fines, caractérisé en ce qu'il comprend un premier transistor (1) et un second transistor (2) reliés à une alimentation stabilisée (6) par l'intermédiaire de résistances d'adaptation (7,13), le premier transistor ayant une borne d'entrée (3) reliée à une source de signaux (4) comportant une série de fronts de tension, une borne de sortie (8) reliée d'une part à une inductance (9) et d'autre part à une borne de commande (10) du second transistor, et une borne de commande (11) reliée à une borne d'entrée (12) du second transistor, le second transistor ayant en outre une borne de sortie (14) reliée à une résistance de charge (15) et à une borne de sortie du générateur d'impulsions.

**Office européen
des brevets**

**RAPPORT DE RECHERCHE
EUROPEENNE**

Numéro de la demande

**EP 90 40 2031**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-3 009 069  (LEE)<br>* Colonne 7, ligne 53 - colonne 9, ligne 68; figures 3,4 *<br>- - - - - | 1 | H 03 K 3/284 |
|  |  |  | **DOMAINES TECHNIQUES RECHERCHES (Int. Cl.5)**<br><br>H 03 K |

Le présent rapport de recherche a été établi pour toutes les revendications

| Lieu de la recherche | Date d'achèvement de la recherche | Examinateur |
|---|---|---|
| La Haye | 26 octobre 90 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

 

& : membre de la même famille, document correspondant